# EUROPEAN PATENT APPLICATION

(11) **EP 2 234 469 A1**
(43) Date of publication of application: **29.09.2010**
(21) Application number: 08858647.4
(22) Date of filing: 12.12.2008
(51) Int. Cl.: H05K 9/00, B32B 7/02, G02B 1/10, G02B 1/11, G02B 5/22, G09F 9/00

(54) **OPTICAL FILTER, OPTICAL FILTER FOR DISPLAY, DISPLAY PROVIDED WITH SUCH FILTER, AND PLASMA DISPLAY PANEL**

(30) Priority: 12.12.2007 JP 2007320352
(71) Applicant: Bridgestone Corporation, Tokyo 104-0031 (JP)
(72) Inventor: MOCHIZUKI, Takayuki, Yokohama-shi Kanagawa 244-8510 (JP); SUGIMACHI, Masato, Kanagawa 244-8510 (JP); TAKANO, Genho, Kanagawa 244-8510 (JP); NAGAYAMA, Hiroyuki, Yokohama-shi Kanagawa 244-8510 (JP)
(74) Representative: Oxley, Robin John George
(86) International application number: PCT/JP2008/072615
(87) International publication number: WO 2009/075348

(57) **Abstract**

An optical filter having excellent durability and a display including the same is provided. The optical filter contains therein a transparent substrate, a mesh-shaped electromagnetic shield layer provided on the substrate, and a functional layer provided on the electromagnetic shield layer. The electromagnetic shield layer of the invention is **characterized by** a surface roughness (Ra) exceeding 0.02 µm.

## Description

### Background of the Invention

### 1. Field of the invention

The present invention relates to an optical filter having functional properties such as an electromagnetic wave shield, an anti-reflection, and a near-infrared shield. The filter is effectively used on a front face of a display such as a plasma display panel (PDP). Furthermore, the present invention relates to an optical filter for a display, a display provided with the optical filter, and a plasma display panel provided with the same.

### 2. Description of the Related Art

Flat-panel displays (FPD) such as a liquid crystal display (LCD), plasma display panel (PDP), field emission display (FED), surface-condition electron-emitter display (SED) and EL display, and other displays such as a CRT display are widely used display devises. In recent years, a large-scale display is mainly used, and a PDP as a next-generation large-scale display device is becoming popular.

For displaying an image, high-frequency wave pulse discharge is carried out in the light emitting part of the PDP. Therefore, unnecessary electromagnetic waves, or infrared radiation, which can cause malfunction of infrared remote controls, are possibly radiated. For protecting the PDPs from the above possibility, known PDPs are generally provided with a filter for a display including an electromagnetic wave shield layer.

Examples of the filter for a display including the electromagnetic wave shield layer are (1) a transparent film having a metallic silver-containing transparent conductive thin layer provided thereon; (2) a transparent film having a conductive mesh layer made of a network-patterned metallic wire or conductive fiber provided thereon; (3) a transparent film having a network-patterned copper foil layer or the like provided thereon, the foil layer being obtained by an etching-process and providing an opening therein; and (4) a transparent film having a mesh-shaped conductive ink layer printed thereon.

The visibility of an image displayed on a display is decreased when a surface of a filter is scratched. Therefore, a filter for a display having a hard coat layer is used. Furthermore, in a large size display including a conventional PDP, it is sometimes difficult to see/recognize images on the display, due to reflection of rays irradiated by an external light source such as a fluorescent lamp. Therefore, a filter for a display having an anti-reflection layer is widely used.

An electromagnetic wave shield layer, a hard coat layer and an anti-reflection layer are provided by overlaying the individual layers upon one another in a display filter, depending upon the usage of the filter. For example, Patent literature 1 discloses a filter for a display in which an electromagnetic wave shield layer, a hard coat layer and an anti-reflection layer are laminated in this order on a transparent substrate.

Further, Patent literature 2 discloses a filter for a display in which a hard coat layer or a near infrared absorption layer is provided on a single substrate film (transparent substrate), or on a mesh-shaped conductive layer. Since such filter for a display includes only a single substrate film, the filter is thin. Accordingly, filters with many functions can be provided.

Patent literature 1: JP-A 2004-163752
Patent literature 2: WO 2006/123612 A1

### Disclosure of the Invention

### Problems to be solved by the Invention

The optical filter disclosed in Patent literature 2 is a thin multi-functional filter and excellent electromagnetic shield property, since the filter includes only one substrate and a mesh-shaped electromagnetic shield layer (conductive layer). When the optical filter is used for a long time or in a high temperature-high humidity environment, however, it became evident that layers can be peeled from each other, for instance, between the electromagnetic shield layer and a functional layer provided on the electromagnetic shield layer such as a hard coat layer and a near infrared absorption layer.

Accordingly, an object of the present invention is to provide an optical filter having improved adhesion property between a mesh-shaped electromagnetic shield layer and a functional layer provided thereon, and excellent durability.

Further, another object of the invention is to provide an optical filter for a display, which has excellent electromagnetic shield property, anti-reflection property and/or near infrared shield property, in addition to excellent durability.

A further object of the invention is to provide a display, which has excellent electromagnetic shield property, anti-reflection property and/or near infrared shield property, in addition to excellent durability.

A still another object of the present invention is to provide a plasma display, which has excellent electromagnetic shield property, anti-reflection property and/or near infrared shield property, in addition to excellent durability.

### Means for solving the problems

The inventors of the invention have found, based on their studies, that the adhesion property between a mesh-shaped electromagnetic shield layer and a functional layer provided thereon such as a hard coat layer or a near infrared absorption layer varies depending on the surface roughness degree of the electromagnetic shield layer. Based on further studies, the inventors found that especially good adhesion property can be obtained when the surface roughness of the electromagnetic shield layer is within a predetermined range.

Namely, the present invention provides:
an optical filter comprising:
   a transparent substrate;
   a mesh-shaped electromagnetic shield layer provided on one side of the transparent substrate; and
   a functional layer provided on a surface of the electromagnetic shield layer, the surface roughness (Ra) of the electromagnetic shield layer being greater than 0.02µm.

In the optical filter, the surface roughness (Ra) of the electromagnetic shield layer can be obtained by measuring the surface of the electromagnetic shield layer (upper surface of the mesh) by use of a digital laser microscope (commercial name: VK-8500, manufactured by Keyence corporation) under predetermined conditions (laser wavelength: 685 nm, output: 0.45 mW, magnification: 2000, and resolution: 0.01 µm), before the preparation of a functional layer on the surface of the electromagnetic shield layer. The length for the measurement was 150 µm.

Preferred embodiments of the optical filter according to the present invention are as follows:
(1) The surface roughness (Ra) of the electromagnetic shield layer is greater than 0.02µm and 0.50µm or less. When the surface roughness (Ra) is 0.02µm or less, the adhesion property of the layer will be insufficient. On the other hand, it is not preferable to prepare the layer having a thickness of greater than 0.50 µm, in view of the productivity and the manufacture cost.
(2) The mesh-shaped electromagnetic shield layer consists of a metallic layer and a blackening layer provided thereon. Depending on the blackening degree, the surface roughness (Ra) can be adjusted.
(3) The electromagnetic shield layer is prepared by successively overlaying a metallic layer, a metal plated layer, and a blackening layer in this order. Depending on the blackening degree, the surface roughness (Ra) can be adjusted.
(4) The blackening layer is made of a nickel-zinc alloy, or nickel-tin alloy. A black alloy conductive layer having excellent black degree and conductivity can be prepared from the above-mentioned alloys. The excellent adhesion property between the electromagnetic shield layer and the functional layer can be improved by decreasing the total thickness of the electromagnetic shield layer.
(5) The thickness of the electromagnetic shield layer is in the range of 0.01 to 8 µm. By the electromagnetic shield layer with the above thicknesses, it is possible to maintain the excellent adhesion property between the electromagnetic shield layer and the functional layer. Further, it is possible to prepare a functional layer, which has excellent surface smoothness, transparency, and visibility, on the electromagnetic shield layer.
(6) The functional layer is a hard coat layer or a near infrared absorption layer. The mesh-shaped electromagnetic shield layer having the above-discussed surface roughness (Ra) can be preferably used, especially when the functional layer is a hard coat layer. This is because the adhesion property with respect to the hard coat layer tends to be decreased.
(7) The optical filter further comprises a low refractive index layer on the hard coat layer.
(8) A hard coat layer as the functional layer is provided on the electromagnetic shield layer on the transparent substrate; and a near infrared absorption layer is provided on another side of the transparent substrate, with respect to the mesh-shaped electromagnetic shield layer.
(9) A transparent adhesive layer is further provided on the near infrared absorption layer.
(10) The transparent substrate is made of a plastic film.
(11) The optical filter of the invention is for a display panel.

The present invention also provides:
an optical filter for a display characterized in that the optical filter is applied to a glass plate by a transparent adhesive agent.

The present invention also provides:
a display apparatus, particularly a plasma display comprising:
   an image display glass plate; and
   the above-discussed optical filter of the invention applied to the surface of the image display glass plate.

### Effect of the Invention

According to the present invention, an optical filter comprises an electromagnetic shield layer having a predetermined surface roughness (Ra), and a functional layer such as a hard coat layer provided on the electromagnetic shield layer. Based on the above-mentioned structure, an optical filter can be obtained, which has improved adhesion property between the electromagnetic shield layer and the functional layer. Such optical filter having an excellent durability is suitable for a display. Therefore, the optical filter of the invention is applied to a display surface of e.g., a plasma display panel (PDP), or EL display. Accordingly, a display having excellent durability can be obtained.

### Brief Description of the Drawings

[Fig. 1] Fig. 1 is a schematic sectional view for showing an example of an optical filter for a display according to the present invention.
[Fig. 2] Fig. 2 is a plane view of the optical filter shown in Fig. 1.
[Fig. 3] Fig. 3 is a partial enlarged perspective view of the optical filter shown in Fig. 2.
[Fig. 4] Fig. 4 is a schematic cross section for showing a preferred and modified embodiment of an optical filter of the present invention.
[Fig. 5] Fig. 5 is a schematic cross section for showing a preferred and modified embodiment of an optical filter of the present invention.
[Fig. 6] Fig. 6 is a schematic cross section for showing a preferred and modified embodiment of an optical filter of the present invention.

### Explanation of reference number

| | |
|---|---|
| 11,41,51,61 | Transparent substrate |
| 12,42,52,62 | Electromagnetic shield layer |
| 43,53,63 | Hard coat layer |
| 55,65 | Near Infrared absorption layer |
| 56, 66 | Transparent adhesive agent |

### Detailed Description of Preferred Embodiments

Firstly, the optical filter of the present invention is explained by referring to the figures.

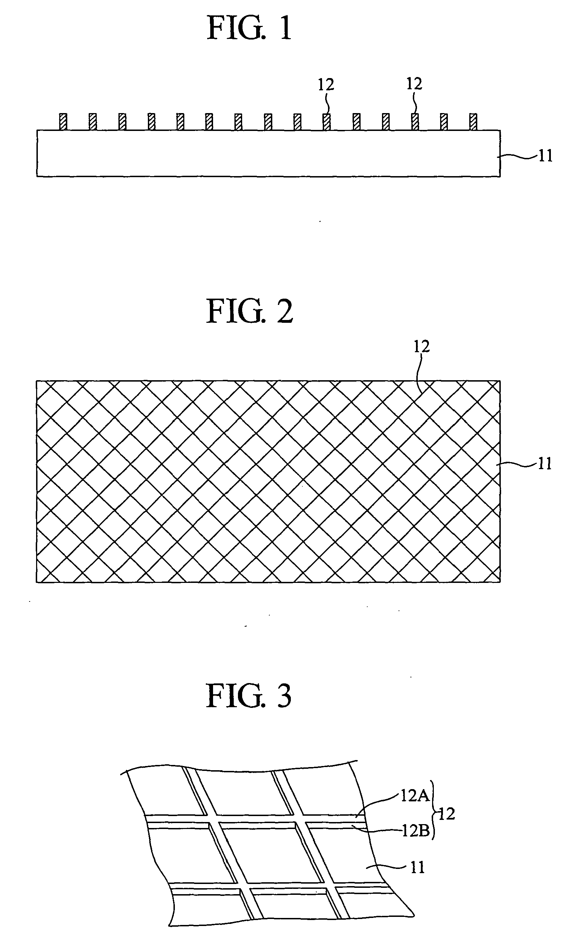

Fig. 1 is a schematic sectional view of an optical filter of the present invention, wherein a functional layer has not yet been provided.

In Fig. 1, a mesh-shaped electromagnetic shield layer 12 is provided on a surface of a transparent substrate 11. The actual number of grids in the mesh is much greater, compared to the figure.

Fig. 2 shows a plane view when Fig. 1 is viewed from the top. Therein, the mesh-shaped electromagnetic shield layer 12 is prepared on the surface of the transparent substrate 11. In the invention, the electromagnetic shield layer 12 has a surface roughness (Ra) in a predetermined range.

Fig. 3 is a partial enlarged perspective view of the electromagnetic shield layer 12 provided on the surface of the transparent substrate 11 shown in Fig. 2. The electromagnetic shield layer has a surface including an electromagnetic shield layer upper surface 12A and an electromagnetic shield layer lateral surface 12B. In the present invention, the measurement of the surface roughness (Ra) is carried out mainly with respect to the electromagnetic shield layer upper surface 12A.
The electromagnetic shield layer lateral surface 12B has a surface roughness which is the same as that of the electromagnetic shield layer upper surface 12A.

The surface roughness (Ra) of the electromagnetic shield layer 12 of the present invention is greater than 0.02 µm. In the optical filter, the surface roughness (Ra) of the electromagnetic shield layer can be obtained by measuring the surface of the electromagnetic shield layer (upper surface of the mesh) by use of digital laser microscope (commercial name: VK-8500, manufactured by Keyence corporation) under predetermined conditions (laser wavelength: 685 nm, output: 0.45 mW, magnification: 2000, and resolution: 0.01 µm), before a functional layer is provided on the surface of the electromagnetic shield layer. The length for the measurement was 150 µm.

The surface of the electromagnetic shield layer 12, in general, is prepared as a metallic layer or a metal-containing layer. Therefore, the adhesion property, with respect to the layer 12, of functional layer such as a hard coat layer formed (preferably by coating) on the surface of the electromagnetic layer 12 is not satisfactory. Rather, the functional layer tends to be peeled from the electromagnetic layer 12. Especially when the hard coat layer is applied to the electromagnetic shield layer 12, the peeling-off tendency is considerably observed. Therefore, the inventors of the present invention have variously studied on the improvement of the above-discussed adhesion property between the layers. The inventors studied surface roughness control of the electromagnetic shield layer 12. As a result, it was found that the adhesion property can be improved to a great extent, when the surface roughness (Ra) of the electromagnetic shield layer 12 is controlled to exceed 0.02 µm. It is more preferable to have a surface roughness (Ra) greater than 0.02 µm, and 0.05 µm or less. The surface roughness in the range of 0.07 to 0.15 µm is particularly preferable. Generally speaking, when the surface roughness (Ra) is less than 0.02 µm, the adhesion property becomes improper. While when the surface roughness of the electromagnetic shield layer exceeds 0.05 µm, there is a tendency that the productivity and the manufacturing cost result in unfavorable.

The mesh-shaped electromagnetic shield layer is, in general, a metallic layer or a metal-containing layer (e.g., a metal deposition layer, a metal foil layer, or a layer wherein metal particles are dispersed in a binder), or a metal plated layer and/or a blackening layer formed on the metallic layer or a metal-containing layer. In the present invention, the mesh-shaped electromagnetic shield layer is preferably configured as follows: a metallic layer; a laminate film consisting of a metallic layer and a metal plated layer provided on the metallic layer; a laminate film consisting of a metallic layer and a blackening layer provided on the metallic layer; or a laminate film consisting of a metallic layer, a metal plated layer and blackening layer, successively overlaid in this order. In the case of the metal deposition layer, it is easy to control the surface roughness. Further, in the metal deposition layer, it is possible to obtain a mesh-shaped layer with a small mesh line width, a small mesh thickness (mesh height), and a high opening ratio. The provision of the metal plated layer is preferable for easily adjusting the conductivity and the surface roughness (Ra). The laminate film consisting of a metallic layer and a blackening layer provided thereon is preferable for adjusting the surface roughness (Ra) depending on the blackening degree.

The electromagnetic shield layer 12 having the above-discussed surface roughness can be obtained, for example, by appropriately adjusting the deposition conditions, plating conditions, or blackening conditions when the metal deposition layer, plated layer, or blackening layer is used, respectively. The details will be discussed later.

As the functional layer, it is preferable to use a hard coat layer or a near infrared absorption layer. Further, it is possible to use an adhesive layer for the functional layer. Particularly when the functional layer is a coated layer such as a hard coat layer, the adhesive property of the layer tends to be decreased. Therefore, it is preferable to use a mesh-shaped electromagnetic shield layer having a predetermined surface roughness (Ra) of the present invention.

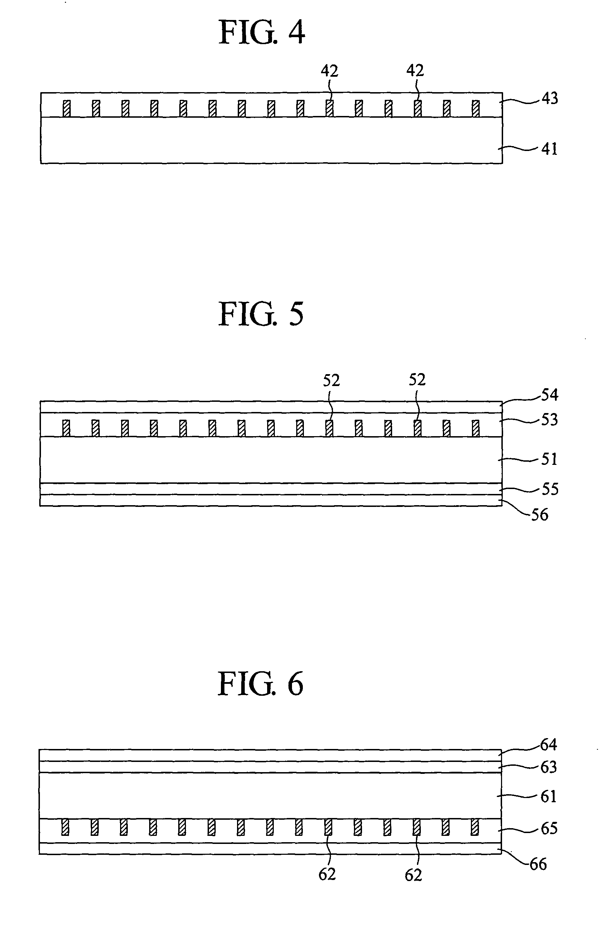

Fig. 4 shows an optical filter which is a preferred embodiment, including a hard coat layer as a functional layer in addition to the optical filter of Fig. 1. In the figure, an electromagnetic shield layer 42 is provided on the surface of a transparent substrate 41, and a hard coat layer 43 is provided on the electromagnetic shield layer 42. In the present invention, the electromagnetic shield layer 42 has the above-discussed predetermined Ra. Therefore, the hard coat layer 43 is strongly adhered to the electromagnetic shield layer 42.

Fig. 5 discloses another embodiment of an optical filter which includes further functional layers in addition to the optical filter of Fig. 4. In Fig. 5, an electromagnetic shield layer 52, hard coat layer 53 and a low refractive layer 54 are successively overlaid on one surface of a transparent substrate 51. Further, a near infrared absorption layer 55 is provided on the other surface of the transparent substrate 51, and a transparent adhesive layer 56 is provided thereon. The hard coat layer 53 is strongly adhered to the electromagnetic shield layer 52. By the provision of the transparent adhesive layer 56, it is easy to apply the optical filter to an image display surface of a display.

Fig. 6 shows an optical filter of the present invention, as a further preferred embodiment. In Fig. 6, a hard coat layer 63 and a low refractive index layer 64 are successively overlaid in this order on one surface of a transparent substrate 61. The near infrared absorption layer 65 is strongly adhered to the electromagnetic shield layer 62. It is possible to omit the low refractive index layer 64.

The spaces/voids defined by the mesh-shaped electromagnetic conductive layers 12, 42 and 52 are filled, as discussed above, with the hard coat layers 43 or 53 or an antiglare layer. By this configuration, the transparency of the optical filter is improved. When the spaces are not filled with the hard coat layers, it is preferable to fill the spaces by other layer, such as a near infrared absorption layer or a transparent resin layer which is for an exclusive use for filling the spaces.

The low refractive layer 54 or 64 constitutes an anti-reflection layer. That is to say, a composite film comprising the hard coat layer and the low refractive index layer formed on the hard coat layer, effectively exhibits an anti-reflection effect. A high refractive index layer may be provided between the low refractive index layer and the hard coat layer. Hence, the anti-reflection function is enhanced.

It is possible to omit the provision of the low refractive index layer. Namely, it is possible to only provide the transparent film and the hard coat layer which has reflection index greater or smaller (preferably smaller) than that of the transparent film. The hard coat layer and the low refractive index layer, etc. are generally formed by coating. Coating operation is preferable in view of productivity and economy.

The abovementioned near-infrared absorption layer 55 or 65 has a radiation blocking function in PDP, i.e., a function for blocking unnecessary light such as neon irradiation. Generally speaking, the near-infrared absorption layer contains a pigment/colorant having absorption maximum at 800 to 1200nm. The transparent adhesive layer 55 or 65 is generally provided for an easy installation to a display. An exfoliative sheet may be provided on the transparent adhesive layer.

The above embodiment was an optical filter for a display comprising a single transparent substrate (in general, a transparent film). Alternatively, two transparent films may be used in the optical filter of the invention. The optical filter can be obtained by the following process:
Namely, a conductive layer is provided on a first transparent film (which, in general, has a near-infrared absorption layer or the like on the back side). A second transparent film is provided, which has a hard coat layer and an anti-reflection layer such as a low refractive index layer on the second transparent film. On the conductive layer provided on the first transparent film, the second transparent film is laminated by the application, if necessary, of an adhesive layer provided at the back side of the second transparent film.
Alternatively, an electromagnetic shield layer, a hard coat layer and an anti-reflection layer such as a low refractive layer are provided on the surface of the transparent film in this order. Further, a near-infrared absorption layer is provided on a surface of another transparent film and a transparent adhesive layer is provided on the near-infrared absorption. Then, the surfaces of two transparent films, where no layers are provided, are bonded with each other. The former laminate can be prepared by a process of the present invention.

Two transparent films are employed when it is favorable for the manufacture. However, it could be disadvantageous to use two transparent films because the increased thickness would be too bulky.

The optical filter including a single transparent substrate can be obtained, for instance, as follows. An electromagnetic shield layer is provided so as to cover the entire surface of a plastic film. Then, a hard coat layer and an anti-reflection layer such as a low refractive index layer are provided on the electromagnetic shield layer. Edges of the electromagnetic shield layer can be removed to prepare an electrode part (earth electrode). Alternatively, it is possible to prepare electrode parts by overlaying the layers with the electromagnetic shield layer protruded from the other layers.

Materials used in the optical filter for a display of the present invention are explained in detail below.

The film is generally a transparent film, particularly a transparent plastic film. The materials may be anything having transparency (the transparency meaning transparency to visible light). Examples of the material of the plastic film include polyester such as polyethylene terephthalate (PET) and polybutylene terephthalate, polymethyl methacrylate (PMMA), acrylic resin, polycarbonate (PC), polystyrene, triacetate resin, polyvinyl alcohol, polyvinyl chloride, polyvinylidene chloride, polyethylene, ethylene-vinyl acetate copolymer, polyvinyl butyral, metal ion-crosslinked ethylene-methacrylic acid copolymer, polyurethane and cellophane. Preferred are polyethylene terephthalate (PET), polycarbonate (PC), polymethyl methacrylate (PMMA), because of high resistance to processing load such as heat, solvent and bending and excellent transparency. Especially, PET is preferred because of excellent processing properties.

The transparent film has a thickness generally in the range of 1 µm to 5 mm.

Examples of the mesh-formed electromagnetic wave shield layer provided on the transparent substrate are (1) those prepared from a metal fiber or an organic fiber covered with a metal; (2) a layer made from a metal such as copper; and (3) a binder resin wherein conductive particles are dispersed. Moreover, a plated layer can be provided on the above layers (1), (2) or (3). Furthermore, the layers (1) to (3) may be subjected to a blackening treatment. In addition to the above, a plated layer prepared from a black metal, for example, nickel-based metal is also preferably used.

The mesh-shaped electromagnetic shield layer of the invention can be prepared so that the surface resistance value of the optical filter to be obtained becomes generally not more than 10 Ω/□, preferably in the range of 0.001 to 5 Ω/□, especially in the range of 0.005 to 5 Ω/□.

As the metal for (1) the metal fiber and the organic fiber coated with a metal constituting the mesh-shaped conductive layer, copper, stainless steel, aluminum, nickel, titanium, tungsten, tin, lead, iron, silver, carbon or an alloy thereof, preferably copper, stainless steel, or nickel can be used.

As organic materials of the organic fiber coated with metal, polyester, nylon, vinylidene chloride, aramid, vinylon, or cellulose can be used.

For the metals of (2) the metallic layer, copper, stainless steel, aluminum, nickel, iron, brass or alloys thereof, preferably copper, stainless steel or aluminum can be used.

The electromagnetic shield layer (2), for instance, can be obtained by preparing a metal foil from the above-mentioned metals in accordance, for example, with metal deposition on a transparent substrate, and performing pattern etching so as to form a mesh. When the thickness of the metal foil is excessively small, the handling property of the foil and the workability of pattern etching are reduced. On the other hand, when the thickness of the metal foil is excessively large, the thickness of the resultant filter is increased and the time required for etching procedure is lengthened. Therefore, the thickness of the conductive layer preferably is in the range of 1 to 200 µm.

The etched pattern does not have any restrictions and may have any shapes. For example, a metallic foil is in the form of a lattice can be used, wherein square openings (pores) are formed. Alternatively, a metallic foil in the form of a punching metal, obtained by forming circle, hexagon, triangle or ellipse openings in a foil, can also be used. The openings may be regularly arranged or irregularly arranged to have a random pattern. The area proportion of the openings to the projection of the metal foil is preferably in the range of 20 to 95%.

In addition to the above, a mesh-shaped electromagnetic shield layer can be preferably used. The mesh-shaped electromagnetic shield layer can be obtained by forming dots on a film, by use of a material soluble in a solvent, and forming a conductive material layer (preferably a metal deposition layer) on the film. By bringing the film into contact with the solvent, the dots and the conductive materials on the dots are removed. Thus, a mesh-shaped conductive layer is obtained.

Further, the mesh-shaped electromagnetic shield layer can be prepared as follows. First, a mesh-shaped image is printed on a transparent substrate by use of an electroless plating catalyst ink. Then, the previously discussed metal is applied to the mesh shaped electroless plating catalyst layer by electroless plating. Consequently, a mesh-shaped electromagnetic shield layer is obtained.

Various inks can be used as the electroless plating catalyst ink. For example, an ink comprising an electroless plating catalyst, a binder resin, and an organic solvent can be used. As the electroless plating catalyst, chlorides, hydroxides, oxides, sulfates or ammine complex including ammonium salt of a metal such as palladium, silver, platinum or gold can be used. Palladium compound, especially palladium chloride is particularly preferred. Further, metal complex oxides or metal complex oxide hydroxides can be used as the electroless plating catalyst. As the metal complex oxides, PdSiO₃, Ag₂SiO₃, PdTiO₃, Ag₂TiO₃, PdZrO₃ and Ag₂TiO₃ can be used. Preferable examples of the binder resin are acrylic resins, polyester resins, polyurethane resins, and vinyl chloride resins. Further, it is preferable that the electroless plating catalyst ink applied to the transparent substrate is dried by heating at a temperature in the range of 80 to 160 °C, particularly in the range of 90 to 130°C.

The electroless plating can be performed in an electroless plating bath at room temperature or at an elevated temperature in accordance with a conventional method.

The above-discussed electromagnetic shield layer can be prepared to be thin so as to have a thickness (height) in the range of 0.01 to 8 µm. The electromagnetic shield layer having thickness in the range of 0.01 to 8 µm is preferable when further functional layer(s) is prepared by coating on the electromagnetic shield layer. When the electromagnetic shield layer is prepared by coating, the freedom to choose the material for an undercoat layer (which is prepared for obtaining excellent adhesion between the transparent substrate and the conductive material layer, and is provided below the electromagnetic shield layer) is increased. Namely, it is possible to prevent the undercoat layer from being discolored by the effect of a solvent in the coated layer. Therefore, an optical filter with a high quality can be obtained.

(3) In the electromagnetic shield layer wherein conductive particles are dispersed in the binder resin, it is possible to use as the conductive particles, metals such as aluminum, nickel indium, chromium, gold, vanadium, tin, cadmium, silver, platinum, copper, titanium, cobalt, or lead, or the alloys of these metals, or conductive oxides such as ITO, indium oxide, tin oxide, zinc oxide, indium oxide-tin oxide (ITO, so-called indium-doped tin oxide), tin oxide-antimony oxide (ATO, so-called antimony-doped tin oxide), zinc oxide-aluminum oxide (ZAO, so-called aluminum-doped zinc oxide). Among these, ITO is preferred..

Examples of the binder resins are acrylic resin, polyester resin, epoxy resin, urethane resin, phenolic resin, maleic resin, melamine resin, urea resin, polyimide resin, and silicon-containing resin. Of these resins, thermosetting resins are preferably used.

The mesh pattern in the electromagnetic shield layer can have any shape without any restriction. For example, electromagnetic shield layer can be in the form of a lattice, which is obtained by forming square openings (pores) in the layer. Further the electromagnetic shield layer can be in the form of a punching metal, which is obtained by forming circle, hexagon, triangle or ellipse openings in the layer. The openings may be regularly arranged or irregularly arranged to have a random pattern.

It is preferable that the mesh in the mesh-shaped electromagnetic shield layer has a line width of 1 µm to 50 µm and opening ratio of 60 to 95%. Further preferred is a mesh having a line width in the range of 10 to 40 µm, particularly in the range of 20 to 40µm, and opening ratio of 60 to 80%. When the mesh-shaped conductive layer has a line width more than 50 µm, the electromagnetic wave shield property is improved, but lines of the electromagnetic shield layer becomes unfavorably prominent. On the other hand, a line width less than 1 µm has a mesh with a decreased strength that is difficult to handle. Moreover, the conductive layer with an opening ratio of more than 95% will result in an insufficient electromagnetic shield property. When the conductive layer has an opening ratio of less than 60%, the amount of light transmitted from a display tends to be insufficient.

The opening ratio (aperture ratio) of the electromagnetic shield layer is the proportion of the area of the opening portion to the area as the projection of the layer.

Preferably, a metal plated (metallic deposit) layer is further provided on the electromagnetic shield layer in order to increase the conductivity. In the present invention, the laminate including the metal plated layer is also called the electromagnetic shield layer. The plated layer can be formed by conventional electrolytic plating and electroless plating. Examples of the metals used in the plating generally include copper, copper alloy, nickel, aluminum, silver, gold, zinc and tin. Copper, copper alloy, silver or nickel is preferred. Particularly, copper or copper alloy is preferred in view of economic efficiency and conductive property. It is possible to perform the aforementioned blackening treatment with respect to the metal plated layer.

It is also preferable to perform a blackening treatment with respect to the electromagnetic shield layer, particularly to a surface of the metallic layer.

It is possible to apply a known blackening treatment depending on the metal included in the electromagnetic shield layer, and to use a known blackening treatment liquid depending on the treatment. Examples of the blackening layer, in general, are oxidation treatment, sulfide treatment, chromium plating treatment, and black metal alloy plating treatment. When the plating metal in the electroplating bath is copper, it is possible to perform oxidation treatment, sulfided treatment, chromium plating treatment and metal alloy plating treatment. Oxidation treatment is particularly preferable. This is because the treatment of waste water is easy and environmental safety is attained in the oxidation treatment.

When the oxidation treatment is carried out as the blackening treatment, it is possible, in general, to use an aqueous solution of a mixture including hypochlorite and sodium hydrochloride, and an aqueous solution of a mixture including peroxodisulfuric acid and sodium hydrochloride. From an economical view point, the aqueous solution including hypochlorite and sodium hydrochloride is preferred.

When the sulfided treatment is carried out as the blackening treatment, it is possible, in general, to use aqueous solutions including potassium sulfide, barium sulfide, ammonium sulfide. It is preferable to use potassium sulfide and ammonium sulfide. Ammonium sulfide is particularly preferably used, as it can be used at a low temperature.

When the chromium plating treatment is carried out as the blackening treatment, it is possible, in general, to use an aqueous solution of acid and acetic acid, and an aqueous solution of chromic acid and fluorosilicic acid. From an economical view point, an aqueous solution of chromic acid and acetic acid is preferred.

When black metal alloy plating treatment is carried our as the blackening treatment, electroplating or electroless plating method can be used. Preferable examples of the black metal alloy are nickel-zinc alloy, and nickel-tin alloy. By use of the black metal alloy, a black metal alloy conductive layer having excellent blackening degree and conductivity can be obtained, and hence the entire thickness of the electromagnetic conductive layer can be decreased.

The weight ratio of the nickel and zinc or tin (Ni/Zn) in the blackening layer made of nickel and zinc or tin preferably is in the range of 0.4 to 1.4, and in particular in the range of 0.2 to 1.2. Based on this proportion, it is possible to obtain a blackening layer, i.e., a uniform black color tone, and an electromagnetic shield layer having a large antiglare property even with a small thickness.

Even when a blackening layer is prepared from a black metal alloy for imparting antiglare property, the conductivity of the electromagnetic shield layer can be satisfactorily secured. The electromagnetic layer has a surface resistivity of 1 Ω/□ or less, particularly 0.3 Ω/□ or less. The surface resistivity of the electromagnetic shield layer can be measured by four-point probe method (Loresta AP, manufactured by Mitsubishi Oil Company).

In the present invention, as discussed above, a metallic layer, a metal-containing layer, a metal plated layer, and a blackening layer can be used as the electromagnetic shield layer. It is particularly preferable that the electromagnetic shield layer is a lamination layer including the metallic layer and the blackening layer successively overlaid in this order, and a lamination layer including the metallic layer, metal plated layer and the blackening layer successively overlaid in this order.

The thickness of the electromagnetic shield layer is particularly preferably in the range of 0.01 to 8 µm, particularly in the range of 0.02 to 6 µm. Excellent adhesive property between the electromagnetic shield layer and the functional layer can be maintained by the electromagnetic shield layer having the above-mentioned thickness. In addition to the above, a functional layer having excellent surface smoothness, transparency and visibility can be formed on the electromagnetic shield layer with the above-mentioned thickness.

Therefore, the electromagnetic shield layer including the metallic layer and the blackening layer in this order preferably has the metallic layer in the range of 0.009 to 7 µm, particularly in the range of 0.01 to 5 µm, and the blackening layer in the range of 0.001 to 1 µm, particularly in the range of 0.01 to 1 µm.

Further, in the electromagnetic shield layer including the metallic layer and the blackening layer overlaid in this order preferably has the metallic layer having a thickness in the range of 0.009 to 3 µm, particularly in the range of 0.05 to 3 µm; the metal plated layer having a thickness in the range of 0.01 to 4 µm, particularly in the range of 1 to 2 µm, and the blackening layer in the range of 0.001 to 1 µm, particularly in the range of 0.01 to 1 µm.

By optimizing the thickness of the electromagnetic shield layer as mentioned above, the functional layer formed on the electromagnetic shield layer can have an excellent smoothness. The surface roughness (Ra) of the functional layer can be measured by use of a surface roughness meter (SURFCOM480A available from Tokyo Seimitsu Co., Ltd) in accordance with JIS B0601-2001.

The electromagnetic shield layer having the predetermined thickness of the invention can be formed, for instance, as follows:

In the case of providing the metal deposition layer, for example, obtained by vacuum deposition using copper, it is preferable to carry out the deposition at a pressure of 10⁻⁷ to 10⁻³ Torr, a substrate temperature of 10 to 30 °C, and deposition rate of 30 to 100 nm/min are preferred.

In the case of providing a metallic layer, for example, obtained by an electroless plating process, a transparent substrate having an electroless catalyst layer is immersed for 30 sec to 60 min in an electroless plating bath of pH 12 to 13.5, preferably pH 12.5 to 13, at a temperature of 50 to 90 °C. In the process, the bath includes 1 to 100 g/L, particularly 1 to 20 g/L of an aqueous copper salt such as copper sulfate, 0.5 to 10 mg/L, particularly 1 to 10 mg/L of a reducing agent such as formaldehyde, and 20 to 100 g/L, particularly 30 to 70 g/L of a complexing agent such as EDTA.

When the deposition layer or the metallic layer is plated, a mixed liquid including copper sulfate, sulfuric acid and water can be used as a plating liquid. A film having a deposition layer is used as a cathode. The metal plating treatment can be performed at a cathode current density of 0.1 to 15 A/cm², for 1 to 10 minutes.

When the surface of the metallic layer is subjected to blackening treatment, it is preferable, for instance, to use an aqueous solution of a mixture including hypochlorite and sodium hydrochloride. When a material including conductive particles dispersed in a binder resin is formed into a layer, it is preferable, e.g., to have a mean diameter of the conductive particles in the range of 1 to 500 nm.

When the blackening treatment is carried out by zinc-nickel alloy plating, an aqueous solution of a mixture including zinc chloride, nickel chloride and potassium chloride can be used. It is preferable that the pH of the aqueous solution is adjusted to be in the range of 9 to 12, and that the cathode current density is adjusted to be in the range of 0.1 to 15 A/dm² for plating treatment.

In the present invention, the anti-reflection layer is obtained as a composite film including a hard coat layer and a low-refractive index layer provided on the hard coat layer. The low-refractive index layer has a refractive index lower than that of the hard coat layer. It is possible to further provide a high-refractive index layer between the hard coat layer and the low-refractive index layer. The low- refractive index layer is a layer having a refractive index lower than that of an adjacent layer (hard coat layer or high-refractive index layer).

The exclusive use of the hard coat layer is effective as the anti-reflection layer, the hard coat layer having a refractive index lower than that of the substrate. When the refractive index of the substrate is low, a composite film including a hard coat layer having a refractive index higher than that of the transparent film and the low-refractive index layer formed on the hard coat layer, or a composite layer including a high-refractive index layer on the low-refractive index layer can be used.

As the hard coat layer, a layer including as the main component a synthetic resin composition can be used. Examples of the layer are an acrylic resin layer, an epoxy resin layer, a urethane resin layer, and a silicone resin layer. Generally speaking, the thickness of the hard coat layer is in the range of 1 to 50 µm, preferably in the range of 1 to 15 µm. The synthetic resin composition is, in general, a thermosetting resin composition or ultraviolet curable resin composition, and preferably an ultraviolet curable resin composition. The ultraviolet curable resin composition is preferably used, because the composition can be cured in a short time, has excellent productivity and is easily removed by a laser.

Examples of the thermosetting resin include phenol resin, resorcinol resin, urea resin, melamine resin, epoxy resin, acrylic resin, urethane resin, furan resin and silicone resin.

The use of the curable resin compositions does not have any restriction. The curable resin compositions which are polymerizable by heat, active rays, radioactive rays/radiations can be used. Examples of the curable resin composition are polyfunctional (meth) acrylate, epoxy-based and oxcetane-based curable resins (monomer, oligomer, and polymer). Among these, ultraviolet curable resin compositions containing as a main component polyfunctional (meth) acrylate or the like are preferably used.

The polyfunctional (meth)acrylate to be used is not particularly restricted. Examples of the polyfunctional (meth)acrylate are dipentaerythritol hexa(meth)acrylate, dipentaerythritol penta(meth)acrylate, dipentaerythritol (meth)tetraacrylate, dipentaerythritol tri(meth)acrylate, pentaerythritol tetra(meth)acrylate, pentaerythritol tri(meth)acrylate, trimethylolpropane tri(meth)arylate, trimethylolethane tri(meth)acrylate, hexanediol di(meth)acrylate, and diethyleneglycol di(meth)acrylate. In the present invention, "(meth) acrylate" means "acrylate or methacrylate".

Polyfunctional (meth)acrylate including hydroxyl-containing (meth)acrylate in an amount of at least 15 wt.%, particularly in the range of 20 to 80 wt.% is preferably used, from which a hard coat layer having excellent hard coat property and scratch resistance can be formed.

Preferred examples of the hydroxyl-containing (meth)acrylate are 2-hydroxyethyl (meth)acrylate, 2-hydroxypropyl (meth)acrylate, 2-hydroxyisopropyl (meth)acrylate, 2-hydroxybutyl (meth)acrylate, propyleneglycol mono(meth)acrylate, ethyleneglycol mono(meth)acrylate, (poly)alkyleneglycol monoacrylate, and adducts of these monomers and lactones (e.g. ε-caprolactone) such as caprolactone-modified 2-hydroxyethyl(meth)acrylate.

Photopolymerization initiators of the ultraviolet curable resin can be optionally selected depending upon the properties of the ultraviolet curable resin to be used. Examples of the photopolymerization initiators include acetophenone type initiators such as 2-hidroxy-2-methyl-1-phenylpropane-1-on, 1-hydroxycyclohexylphenylketone and 2-methyl-1-[4-(methylthio)phenyl]-2-morphorinopropane-1,2,2-dietoxyace tophenone; benzoin type initiators such as benzylmethylketal; benzophenone type initiators such as benzophenone, 4-phenylbenzophenone and hydroxybenzophenone; and thioxanthone type initiators such as isopropylthioxanthone and 2,4-diethythioxanthone. Further, as special type, methylphenylglyoxylate can be used. Especially preferred are 2,2-diethoxyacetophenone, 2-hidroxy-2-methyl-1-phenylpropane-1-on, 1-hydroxycyclohexylphenylketone, 2-methyl-1-[4-(methylthio)phenyl]-2-morphorinopropane-1-on and benzophenone. These photopolymerization initiators can be employed, if desired, together with one or more kinds of a conventional photopolymerization promoter such as a benzoic acid type compound (e.g., 4-dimethylaminobenzoic acid) or a tertiary amine compound by mixing these with the promoter in optional ratio. Only the initiator can be employed singly or in combination of two or more kinds. Especially, 1-hydroxycyclohexylphenylketone (Irgercure 184, available from Ciba-Specialty Chemicals) is preferred.

The initiator is preferably contained in the range of 0.1 to 10% by weight, particularly 0.1 to 5% by weight based on the resin composition.

By use of the ultraviolet curable resin, a hard coat layer having improved hardness can be easily obtained. It is preferable that the hard coat layer has a hardness of 2H or more, particularly a hardness of 3H or more, based on pencil hardness test determined by JIS-K-5400.

The hard coat layer preferably includes fine particles having mean particle size in the range of 0.01 to 1 µm, more preferably in the range of 0.01 to 0.1 µm. The mean particle size of the fine particles is a number average value obtained by observing the cross section of the display filter by an electron microscope (preferably transmission electron microscope) with a magnitude of about 1,000,000, and obtaining circular diameter of equivalent area with respect to at least 100 particles.

The hard coat layer preferably includes the above-discussed fine particles in an amount of 5 to 900 parts by weight, more preferably 200 to 800 parts by weight, and particularly preferably 500 to 800 parts by weight, based on 100 parts by weight of the curable resin. By this configuration, it is possible to impart appropriate surface roughness to the hard coat layer, without decreasing the transparency thereof.

The hard coat layer preferably has a reflective index higher than that of the transparent substrate for obtaining high antireflection property. It is preferable that the reflective index of the hard coat layer is in the range of 1.49 to 1.80, in particular 1.70 to 1.80.

Fine particles having high reflective index are used as the above-mentioned fine particles, for increasing the reflective index of the hard coat layer. Examples of the particles include ITO, TiO₂, ZrO₂, CeO₂, Al₂O₃, Y₂O₃, La₂O₃, LaO₂ and Ho₂O₃. These can be employed singly or in combination of two or more kinds. TiO₂ is preferably used.

It is preferable that the hard coat layer has generally has a thickness in the range of 1 to 200 µm, particularly in the range of 3 to 15 µm.

For increasing the antiglare property in the filter for the display of the present invention, a low-refractive index layer of which refractive index is lower than that of the hard coat layer can be provided on the hard coat layer. The refractive index of the low-refractive index layer is in the range of 1.20 to 1.50, particularly in the range of 1.25 to 1.45. When fine particles are used, those for the low-refractive index layer, which will be discussed layer, can be used.

Conventional layers can be used as the low-refractive index layer, such as a cured layer obtained by dispersing particles such as SiO₂, MgF₂, Al₂O₃, silica, or fluorine resin in a curable resin.

Hollow silica can be preferably used for the fine particles. The mean diameter of the hollow silica is, in general, in the range of 10 to 100 nm, preferably in the range of 10 to 50 nm. The hollow silica having a specific gravity in the range of 0.5 to 1.0, particularly in the range of 0.8 to 0.9 is preferably used. The curable resins discussed with respect to the hard coat layer can be used as the curable resins for the low refractive index layer.

The thickness of the low refractive index layer is in general in the range of 10 to 500 nm, preferably in the range of 20 to 200 nm.

As discussed previously, the antirefrection layer of the invention is a composite film including a hard coat layer having a refractive index greater than that of the transparent substrate, and a low refractive index layer provided on the hard coat layer. For imparting near infrared interception function to the antireflection layer, a near infrared absorbing material, which will be discussed later (e.g. dye/coloring agent) can be mixed and/or kneaded into hard coat layer, etc. Alternatively, it is possible to introduce the near infrared absorbing material to the back surface of the transparent substrate, namely on a side of the substrate without carrying the mesh layer.

It is preferable, in the optical filter of the invention, that a near infrared absorption layer is further provided on a surface of the substrate, opposite to the electromagnetic shield layer. Accordingly, the filter for the display can interrupt the irradiation of infrared rays, which can cause malfunction of infrared remote control systems or the like.

The near-infrared absorption layer (i.e., near-infrared shield layer) is generally obtained by forming a layer containing a coloring agent/dye on a surface of the transparent substrate. The near-infrared absorption layer is prepared by applying a coating liquid, which comprises a synthetic resin such as an ultraviolet- or electron-beam-curable resin, and synthetic resins such as a dye and a binder resin, to the substrate or the like. The layer is completed, if desired, by drying and curing the layer. When the near-infrared absorption layer is used as a film, the film is generally used as a near-infrared cut film, such as a dye-containing film.

The dye generally has absorption maximum in wavelength of 800 to 1200 nm. Examples of the dye include phthalocyanine dyes, metal complexes dyes, nickel dithioren complexes dyes, cyanine dyes, squalirium dyes, polymethine dyes, azomethine dyes, azo dyes, polyazo dyes, diimmonium dyes, aminium dyes, anthraquinone dyes. Preferred are cyanine dyes and squalirium dyes. These dyes can be employed singly or in combination.

Preferred examples of the binder resin include acrylic resin, fluorine resin, polyester resin, vinyl chloride resin, styrene resin, and norbornene resin. These resins can be used alone or as a mixture of two or more.

In the invention, a neon-emission absorption function may be given to the near-infrared absorption layer such that the near-infrared absorption layer has function for adjusting color hue. For this purpose, a neon-emission absorption layer may be provided, or a neon-emission selective absorption dye may be added to the near-infrared absorption layer.

Examples of the neon-emission selective absorption dyes include cyanine dyes, squalirium dyes, anthraquinone dyes, phthalocyanine dyes, polymethine dyes, polyazo dyes, azulenium dyes, diphenylmethane dyes, triphenylmethane dyes. The neon-emission selective absorption dyes are required to have neon-emission selective absorption property at wavelength of approx. 585 nm. It is also necessary for the neon-emission selective absorption dyes to have a small absorption in the visible light wavelength range except for the above-mentioned wavelength. Hence, the dyes preferably have absorption maximum wavelength of 575 to 595 nm having spectrum half bandwidth of 40 nm or less.

It is possible to use a plurality of absorption dyes including dyes for absorbing near-infrared light and dyes for absorbing neon emission light in combination. In that case, it is not necessary for all the absorption dyes to be contained in the same layer, and the absorption dyes can be added to different layers. Such separate addition can be considered, especially when the dyes have insufficient solubilities, the mixed dyes react with each other, or the thermal resistance or moisture resistance of the layer is deteriorated by the mixed application.

As long as the optical properties are not largely affected, it is possible to add a dye for coloration, ultraviolet absorbing agent and antioxidant to the layers.

As to the near-infrared absorption properties of the optical filter for the display of the invention, the transmittance of light in a wavelength range of 850 to 1000 nm preferably is 20% or less, more preferably 15% or less. As to the selective absorption properties of the optical filter, the transmittance of light at a wavelength of 585 nm preferably is 50% or less. The former is effective for reducing the transmittance of a light in the wavelength range, which is considered to cause malfunction of remote control systems in peripheral devices. In the latter case, it is effective to absorb orange light having a peak wavelength in the range of 575 to 595 nm, which affects to the deterioration of color reproductively. Accordingly, red light is rendered more intrinsic, and the reproducibility of colors is improved.

The thickness of the near-infrared absorption layer does not have any limitation. However, the near-infrared absorption layer generally has a thickness of 0.5 to 50 µm, with the near infrared absorption and the visible light transmission properties taking into account.

The near infrared absorption layer preferably includes a coloring agent or a dye for correcting color tone. Alternatively, it is possible to provide a color tone correction layer which includes a dye for correcting color tone in addition to the near infrared absorption layer.

As the dye for correcting color tone, a complementary color is used, that is for adjusting the color balance by neutralizing color tone of yellowish brown to green in the near infrared shield layer. Examples of the coloring agent are generally used materials such as inorganic pigments, organic pigments, organic dyes, and other coloring agents. Examples of the inorganic pigment are cobalt compound, iron compound, chromium compound, and examples of the organic pigment are azo, indolinone, quinacridone, vat, phthalocyanine, and naphthalocyanine compounds. As the organic dye or coloring agent, azo, azine, anthraquinone, indigoide, oxadine, quinophthalone, squalirium, stylbene, triphenylmethane, naphthoquinone, pyrazoline, polymethine compounds can be used. Among these compounds, organic pigments are preferably used, in view of the balance between the coloring property and the durability. The near infrared absorption layer preferably has adhesion property.

The optical filter of the present invention preferably has a transparent adhesive layer further provided on the near infrared absorption layer. The optical filter of the present invention can be easily adhered to an image display glass plate included in a display apparatus by the transparent adhesive layer.

The transparent adhesive layer is to be adhered to a display. Any resins having adhesive function can be used for the layer. Examples of the resin having the adhesive function included in the transparent adhesive layer are ethylene-vinyl acetate copolymer (EVA), ethylene-methyl acrylate copolymer, acrylic resin (e.g., ethylene-(meth)acrylic acid copolymer, ethylene-ethyl (meth) acrylic acid copolymer, ethylene- acrylic acid copolymer, metal-ion crosslinked ethylene-(meth)acrylic acid copolymer), and ethylene copolymers such as partially saponified ethylene-vinyl acetate copolymer, carboxylated ethylene-vinyl acetate copolymer, ethylene-(meth)acrylic acid-maleic anhydride copolymer, ethylene-vinyl acetate-(meth)acrylate copolymer. ( "(Meth)acryl " means "acryl or methacryl"). Besides these polymers, polyvinyl butyral (PVB) resin, epoxy resin, phenol resin, silicone resin, polyester resin, urethane resin, rubber adhesives, thermoplastic elastomers such as SEBS (styrene/ethylene/butylene/styrene) and SBS (styrene/butadiene/styrene) can be used. Excellent adhesion property can be easily obtained by use of acrylic adhesives or epoxy resins.

The thickness of the above-mentioned adhesive layer generally is in the range of 10 to 50 µm, preferably in the range of 20 to 30 µm. The optical filter can be generally attached to a glass plate of a display through the adhesive layer by application of pressure and heat thereto.

The transparent adhesive layer of the invention can further contain a small amount of ultraviolet absorbing agent, infrared absorbing agent, age stabilizer, paint processing aid and colorant. If appropriate, filler such as carbon black, hydrophobic silica or calcium carbonate may be contained.

It is preferable to provide a release sheet on the transparent adhesive layer. Materials for the release sheet are preferably transparent polymers having glass transition temperature of not less than 50°C. Examples of the materials include polyester resins such as polyethylene terephthalate, polycyclohexylene terephthalate, and polyethylene naphthalate; polyamide resins such as nylon 46, modified nylon 6T, nylon MXD6, and polyphthalamide; ketone resins such as polyphenylene sulfide, and polythioether sulfone; sulfone resins such as polysulfone, polyether sulfone, and resins including, as a main component, a polymer such as polyether nitrile, polyacrylate, polyether imide, polyamideimide, polycarbonate, polymethyl methacrylate, triacetylcellulose, polystyrene or polyvinyl chloride. Of these resins, polycarbonate, polymethyl methacrylate, polyvinyl chloride, polystyrene and polyethylene terephthalate can be preferably employed. The thickness is generally in the range of 10 to 200 µm, especially in the range of 30 to 100 µm.

According to the present invention, an filter for a display having excellent durability can be obtained. The optical filter for the display of the invention can be applied/adhered to the surface of an image display glass plate included in a display apparatus such as PDP.

In the PDP display apparatus of the invention, it is possible to directly attach the optical filter for the display to the surface of the glass plate of the PDP as described above since the optical filter generally has a plastic film as a transparent substrate. Therefore, the weight, thickness and cost of PDP itself can be decreased. Further, compared with PDP having a front plate made of a transparent molded body provided on the front surface of the PDP, it is possible in the present invention to remove an air layer having a low refractive index formed between PDP and a filter for PDP. Therefore, the PDP of the invention does not have shortcomings such as the increase of visible-rays reflectivity caused by the interface reflection and the occurrence of the double reflection. Thus, the PDP of the invention has an improved visibility.

In the optical filter of the present invention, it is preferable to form a hard coat layer by applying a coating liquid for forming a hard coat layer containing curable resin on the electromagnetic shield layer prepared in the above-discussed manner.

As the curable resin contained in the coating liquid for preparing the hard coat layer, the previously mentioned polyfunctional (meth)acrylate, epoxy-based and oxcetane-based curable resins can be used. The curable resin of the invention includes materials which are made into a resin by polymerization of (meth)acrylate or the like. As polyfunctional (meth)acrylate, materials including hydroxyl-containing (meth)acrylate in an amount of at least 15 wt.%, particularly in the range of 20 to 80 wt.%, based on the total amount of the curable resin is preferred, from which a hard coat layer having an excellent hard coat property and scratch resistance can be formed, as discussed previously.

For adjusting the viscosity of the coating liquid for preparing the hard coat layer, solvents are usually used. The concentration of the solvent is generally 80 wt.% or less, preferably in the range of 10 to 70 wt.%.

Examples of the solvents are alcohols such as isopropyl alcohol, n-butanol, and sec-butanol; ketones such as methyl ethyl ketone, isobutyl ethyl ketone, and cyclohexanone; esters such as ethyl acetate, butyl acetate; alkyl ethers such as ethylene glycol monobutyl ether (butyl cellosolve), ethylene glycol monophenyl ether, diethylene glycol, diethylene glycol monobutyl ether (butyl carbitol), cellosolve acetate, butyl cellosolve acetate, carbitol acetate, and butyl carbitol acetate; aromatic solvents such as toluene and xylene.

The coating liquid for preparing the hard coat layer can further contain a variety of known additives such as a sensitizer, antifoaming agent, leveling agent, and antioxidant.

For applying the coating liquid for preparing the hard coat layer to the electromagnetic shield layer, wire bar coating, roll coating, spray coating, extrusion coating, curtain coating, dip coating, spin coating, and gravure coating can be used.

Subsequently, the coating liquid for preparing the hard coat layer applied to the electromagnetic layer is dried, and subjected to thermosetting if necessary. It is possible that the coated layer is dried if necessary, and ultraviolet ray is irradiated to the layer.

The drying is carried out, usually in the range of room temperature to about 250°C. When the UV- ray irradiation is performed, it is possible to adopt, as light source used, various sources generating light in the wavelength range of ultraviolet to visible rays. Examples of the source include super-high-pressure, high-pressure and low-pressure mercury lamp, chemical lamp, xenon lamp, halogen lamp, mercury halogen lamp, carbon arc lamp, and incandescent electric lamp, and laser beam. The exposing time is generally in the range of a few seconds to a few minutes, depending upon the kinds of lamp and intensity of light.

When the low-refractive index layer is prepared on the hard coat layer, the previously mentioned method for preparing the hard coat layer can be used except that particles such as SiO₂, MgF₂, Al₂O₃, silica, or fluorine resin are used in place of the particles having mean particle diameter in the range of 0.001 to 2 µm.

In the filter for the display of the present invention, it is preferable that at least a part of the periphery in the electromagnetic shield layer is exposed without a functional layer formed thereon. The exposed part of the electromagnetic shield layer is used as an electrode part for an earth (earth electrode) for the display main body such as a PDP. By the provision of the exposed part, a filter for a display, which can be easily attached to the display and can easily serve as an earth electrode, can be provided.

The exposed part of the electromagnetic layer can be prepared at least at a peripheral part of the electromagnetic shield layer so that the exposed part can easily earth (ground) the display. For example, the exposed parts are intermittently prepared in the peripheral part of the electromagnetic shield layer, or the exposed part can be formed all over the peripheral part. In this case, it is possible that the endmost part of the peripheral part is covered with the functional layer. Namely, the above-mentioned exposed part can be formed without the endmost part of the electromagnetic shield layer being exposed.

For preparing the exposed part(s) in the electromagnetic shield layer as discussed above, the following methods can be used. Namely, the coating portions are adjusted/controlled when the functional layer is obtained by coating, or a predetermined portion of the functional layer is eliminated by burning or decomposing the portion by irradiation of laser beam. As laser irradiation technology, line beam forming, laser beam branch, and double pulse technologies can be used alone or in combination. As the laser beam, YAG laser (double wavelength, triple wavelength), Ruby laser, Excimer laser, semiconductor laser, CO₂ laser, and argon laser.

According to the present invention, an optical filter, which has excellent durability and is appropriately used for a display, can be obtained. It is preferable that the filter for a display of the present invention is applied to a surface of an image display glass plate in a display, by way of a transparent adhesive layer. As the display, a field emission display (FED) including surface-condition electron-emitter display (SED), and a flat-panel displays (FPD) such as a liquid crystal display (LCD), plasma display panel (PDP), and EL display, and other displays such as a CRT display are widely used display devises.

### Examples

The invention is illustrated in detail by referring to the following Examples. The invention is not restricted to the following Examples.

### [Example 1]

### [Example 1]

### 1. Formation of mesh-shaped electromagnetic shield layer

A copper foil having a thickness of 10 µm was attached to the entire surface of an adhesive layer (polyester polyurethane; thickness of 20 nm) provided on the surface of PET film (thickness of 250 µm, S grade, manufactured by Teijin Limited). The copper foil was processed into a lattice pattern (thickness: 10 µm, wire diameter: 30 µm, and pitch: 163 µ m) by etching in accordance with photolithography.

By use of an aqueous solution including a mixture of hypochlorite (10 parts by weight) and sodium hydrochloride (3 parts by weight), the copper foil was treated at 80 °C for 10 minutes. The surface of the copper foil was subjected to blackening treatment so that the surface of the copper foil was changed into copper oxide.

The conductive layer on the surface of the film had wire diameter of 30 µm, pitch of 163 µm and opening ratio of 67%. The mean thickness of the conductive layer (copper layer) was 3.1 µm. The surface roughness (Ra) was 0.12 µm.

### 2. Formation of hard coat layer

An optical filter coating liquid (concentration of solid component: 40 wt.%, viscosity at 25°C: 100cP) containing the components shown below was coated on the PCT film, which has the electromagnetic shield layer, by a bar coater so as to have a dried layer with a thickness of 12 µm, for forming a hard coat layer. After the coated layer was dried in an oven at 80°C for one min, ultraviolet ray in accumulated light amount of 2400mJ/cm² was irradiated to the layer for curing the same. Accordingly, a filter for an optical display was prepared, which has a hard coat layer (thickness of 12 µm) on the mesh-shaped electromagnetic shield layer.

### (Formulation of coating liquid for forming hard coat layer)

| | |
|---|---|
| 2-hydroxy-3-acryloisopropylmethacrylate | 60 parts by weight |
| Dipentaerythritol hexaacrylate | 40 parts by weight |
| TiO₂ particles (mean diameter: 0.1 µm) | 10 parts by weight |
| Polymerization initiator | |
| (Irgacure 184, manufactured by Ciba specialty chemicals) | |
| | 7 parts by weight |
| Isopropyl alcohol (IPA) | 50 parts by weight |
| Methyl ethyl ketone (MEK) | 100 parts by weight |
| Cyclohexanone (CAN) | 25 parts by weight |

### [Comparative Example 1]

### 1. Formation of mesh-shaped electromagnetic shield layer

A 20% of polyvinyl alcohol aqueous solution was printed in a predetermined mesh pattern (dot shapes) on a PET film (thickness: 250 µm, S grade, manufactured by Teijin Limited). Each dot had a square shape having a length of each side of 163 µm. The distance between the dots was 30 µm. The print thickness was approx. 5 µm after being dried.

On the PET film having the above dot pattern, copper was vacuum-deposited to form a copper layer having mean thickness of 1 µm.

Subsequently, the PET film having dot pattern and copper layer was immersed in room-temperature water and rubbed with a sponge for dissolving and removing a belt shaped part. Then, the PET film was rinsed with water, and dried to form a mesh-shaped conductive layer on the PET film.

On the above discussed cupper, a nickel plating was carried out under the following conditions.

### (Electroplating liquid)

Nickel sulphate: 100 g/L, tin(II) chloride: 50 g/L, current density: 1A/dm², temperature: 40°C, time period: 10 min.

The thus obtained mesh-shaped electromagnetic shield layer has a wire diameter: 30 µm, pitch: 163 µm, and opening ratio of 67%. The average thickness of the conductive layer (copper layer) was 2.8 µm. Surface roughness (Ra) was 0.02 µm.

### 2. Formation of hard coat layer

A hard coat layer (thickness: 6.9 µm) was formed on the mesh-shaped electroconductive shield layer in the same way as in Example 1. Therefore, an optical filter for a display was prepared.

### [Example 2]

### 1. Formation of mesh-shaped electromagnetic shield layer

An electroless plating catalyst ink obtained by adding 10 wt.% of electroless plating catalyst (PdCl₂) in a polyester resin was applied in a mesh pattern to the PET film (thickness: 100 µm) by gravure printing. Thereafter, the printed layer was dried at 100°C for 10 minutes. Thus, mesh-shaped electroless plating catalyst layer was obtained. The electroless printing catalyst layer was obtained in the form of a square lattice, obtained by regularly arranging square openings (pores) in the layer. The catalyst layer had a wire diameter of 20 µm, each-side-length of the opening of 191 µm, an opening ratio of 78%, and a thickness of 2 µm.

The electroless plating catalyst layer was subjected to degrease treatment with 5% sulfuric acid. Subsequently, an electroless cupper plating liquid (liquid temperature of 60°C) having the formulation below was used for carrying out an electroless plating. Therefore, a mesh-shaped cupper layer was formed on the electroless plating catalyst layer. The cupper layer was in the form of a square lattice having a regularly arranged square openings in the layer. The electroless plating catalyst layer had a wire diameter of 20 µm, each-side-length of the opening of 191 µm, an opening ratio of 78%, and a thickness of 2 µm.

### (Electroless cupper plating layer)

| | |
|---|---|
| Cupper sulphate pentahydrate | 13 g/L |
| NaOH | 7.5 g/L |
| HCOH | 13 mL |

### Complexing agent

An electrolysis copper plating liquid (liquid temperature of 30°C ) was used for electrolysis plating. A mesh-shaped copper plated layer was prepared on the electroless layer. The electrolysis had a condition of 20A for 10 minutes. A copper plate (size: 600 x 1000 mm) was used for the material for the application, and a cupper ball contained in a titanium case was used for an anode. The electrolysis plated layer was in the form of a square lattice obtained by regularly arranging square openings in the layer. The layer had a wire diameter of 20 µm, each-side-length of the opening of 191 µm, an opening ratio of 78%, and a thickness of 2 µm.

Further, zinc-nickel alloy was plated by use of the blackening treatment liquid as discussed below under the conditions discussed below, with respect to the cupper plated layer. Therefore, a blackening layer (thickness: 2 µm) was formed on the entire surface of the copper plated layer.

### (Formulation of blackening treatment liquid)

A plating liquid of pH 10 was used, which contains ZnCl₂ (Zn²⁺ concentration: 2.0 g/l), NiCl₂ • 6H₂O (Ni²⁺ concentration: 0.5 g/l), and KCl (K⁺ concentration: 250 g/l).

### (Blackening treatment conditions)

| | |
|---|---|
| Temperature of plating liquid: | 40°C |
| Current density: | 5 to 10 A/dm² |
| Plating time period: | 10 seconds |
| Amount of plating liquid: | 120 cm³ |

The thus obtained electromagnetic shield layer was in the from of a square lattice having regularly arranged square openings therein. The electromagnetic shield layer had a wire diameter of 20 µm, a pitch of 191 µm, an opening ratio of 78%, an average thickness of 6 µm, and a surface roughness (Ra) of 0.07 µm.

### 2. Formation of hard coat layer

A hard coat layer (thickness: 7 µm) was prepared on the mesh-shaped electromagnetic shield layer in the same way as in Example 1. Therefore, an optical filter for a display was prepared.

### [Example 3]

### 1. Formation of mesh-shaped electromagnetic shield layer

A 20% of polyvinyl alcohol aqueous solution was printed in dot shapes on a polyethylene terephthalate (PET) film in the form of a strip (width: 600 mm, length: 100 m). Each dot had a square shape having a length of each side of 234 µm. The distance between the dots was 20 µm, and the dots were arranged in the form of a squared lattice. The print thickness was approx. 5 µm after being dried.

On the PET film having the above dot pattern, copper was vacuum-deposited to form a copper layer having average thickness of 4 µm. Subsequently, the PET film having dot pattern and copper layer was immersed in room-temperature water and rubbed with a sponge for dissolving and removing the dot parts. Then, the PET film was rinsed with water, and dried to form a mesh-shaped copper layer on the entire surface of the polyethylene film.

The copper layer on the film had a squared lattice shape exactly corresponding to a dot negative pattern, having a wire diameter of 20 µm, and an opening ratio of 77%. The average thickness of the copper layer was 4 µm.

With respect to the copper formed on the PET film, zinc-nickel alloy was plated. Accordingly, a blackening layer (wire diameter: 20 µm, each-side-length of the opening: 234 µm, an opening ratio: 85%, thickness: 0.1 µm, surface roughness (Ra): 0.09 µm). Accordingly, a mesh-shaped electromagnetic shield layer including therein the copper layer and the blackening layer was prepared.

### (Plating conditions)

| | |
|---|---|
| Temperature of plating liquid: | 40°C |
| Current density: | 5 to 10 A/dm² |
| Plating time period: | 10 seconds |
| Amount of plating liquid: | 120 cm³ |

### (Formulation of plating liquid)

A plating liquid of pH 10 was used, which contains ZnCl₂ (Zn²⁺ concentration: 2.0 g/l), NiCl₂ • 6H₂O (Ni²⁺ concentration: 0.5 g/l), and KCl (K⁺ concentration: 250 g/l).

### 2. Formation of hard coat layer

A coating liquid was obtained by mixing the following components:

| | |
|---|---|
| Pentaerythritol triacrylate | 80 parts by weight |
| ITO particles (mean diameter: 150 nm) | 20 parts by weight |
| Methyl ethyl ketone (MEK) | 100 parts by weight |
| Toluene | 100 parts by weight |
| Irgacure 184 (manufactured by Ciba specialty chemicals) | |
| | 4 parts by weight |

The thus obtained coating liquid was coated on the entire surface of the above-discussed electromagnetic shield layer by use of a bar coater. The coated layer was cured by the irradiation of ultraviolet ray. Accordingly, a hard coat layer (refractive index: 1.52) having a thickness of 5 µm was formed on the electromagnetic shield layer.

### 3. Formation of low-refractive index layer.

A coating liquid was obtained by mixing the following components:
OPSTAR JN-7212 (Available from JSR Corporation)

| | |
|---|---|
| | 100 parts by weight |
| Methyl ethyl ketone | 117 parts by weight |
| Methyl isobutyl ketone | 117 parts by weight |

The thus obtained coating liquid was coated on the hard coat layer by use of a bar coater, and dried in an oven at 80°C for 5 minutes. Subsequently, the coated layer was cured by the irradiation of ultraviolet ray. Accordingly, a low-refractive index layer (refractive index: 1.42) having a thickness of 90 nm was formed on the hard coat layer

### 4. Formation of near-infrared absorption layer (having color tone adjusting function)

A coating liquid was obtained by mixing the following components:

| | |
|---|---|
| Polymethyl methacrylate | 30 parts by weight |
| TAP-2 | |
| (available from Yamada Chemical Co., Ltd.) | 0.4 parts by weight |
| Plast Red 8380 | |
| (available from Arimoto Chemical Co., Ltd.) | 0.1 part by weight |
| CIR-1085 | |
| (available from Japan Carlit Co., Ltd.) | 1.3 parts by weight |
| IR-10A | |
| (available from Nippon Syokubai Co., Ltd.) | 0.6 parts by weight |
| Methyl ethyl ketone | 152 parts by weight |
| Methyl isobutyl ketone | 18 parts by weight |

The thus obtained coating liquid was applied to the entire surface of the PET film with a bar coater, and dried in an oven at 80°C for 5 minutes. Hence, a near-infrared absorption layer (having color tone adjusting function) having a thickness of 25 µm was formed on the PET film.

### 5. Formation of transparent adhesive layer

A coating liquid was obtained by mixing the following components:

| SK Dyne 1811 L | |
|---|---|
| (Available from Soken Chemical & Engineering Co., Ltd.) | |
| | |
| | 100 parts by weight |

| Hardener L-45 | |
|---|---|
| (Available from Soken Chemical & Engineering Co., Ltd.) | |
| | 0.45 parts by weight |
| Toluene | 15 parts by weight |
| Ethyl acetate | 4 parts by weight |

The thus obtained coating liquid was applied to the above-mentioned near-infrared absorption layer with a bar coater. Hence, a transparent adhesive layer having a thickness of 25 µm was formed on the near-infrared absorption layer.

The haze value of the optical filter for a display, which was prepared in Example 3, was determined by using Full Automatic Direct-Reading Haze Computer HGM-2DP (manufactured by Suga Shikenki K.K.), according to JIS K 7105 (1981). The haze value of the above filter for the display was 3.0%. Moreover, the electromagnetic shield layer had a satisfactory resistance to solvents, and excellent transparency. The surface roughness Ra of the low refractive index layer in the filter for a display, which was prepared in Example 3, was measured in accordance with JIS B0601-2001 by using a surface roughness meter (trade name: SURFCOM480A available from Tokyo Seimitsu Co., Ltd). The low refractive index layer had surface roughness Ra of 0.12, and excellent smoothness.

### [Evaluation of Optical Filter]

### 1. Surface roughness Ra of the electromagnetic shield layer.

The surface roughness (Ra) of the electromagnetic shield layer surface was determined by use of a digital laser microscope (commercial name: VK-8500, manufactured by Keyence corporation) in a predetermined condition (laser wavelength: 685 nm, output: 0.45 mW, magnification: 2000, and resolution: 0.01 µm). The measurement was carried out for a length of 150 µm.

### 2. Adhesion property of the hard coat layer

With respect to the hard coat layer in the optical filter (with respect to the low refractive index layer in the optical filter obtained in Example 3), the adhesive property was evaluated as follows, in accordance with cross cut adhesion test (JIS-D-0202). The adhesion property was evaluated based on the following standards.

○ : 80/100 or more of cross cut pieces remained based on 100 cross cut pieces in the hard coat layer.
△ : less than 80/100 and 50/100 or more of cross cut pieces remained.
× : less than 50/100 of cross cut pieces remained.

**[Table 1]**

| | Adhesive Property |
|---|---|
| Example 1 | ○ |
| Example 2 | ○ |
| Example 3 | ○ |
| Comparative Example 1 | × |

## Claims

1. An optical filter comprising:
a transparent substrate;
a mesh-shaped electromagnetic shield layer provided on one side of the transparent substrate; and
a functional layer provided on a surface of the electromagnetic shield layer, the surface roughness (Ra) of the electromagnetic shield layer being greater than 0.02µm.

2. The optical filter as claimed in Claim 1, wherein the surface roughness (Ra) of the electromagnetic shield layer is greater than 0.02µm and 0.50µm or less.

3. The optical filter as claimed in Claim 1 or 2, wherein the electromagnetic shield layer consists of a metallic layer and a blackening layer provided thereon.

4. The optical filter as claimed in Claim 1 or 2, wherein the electromagnetic shield layer is prepared by successively overlaying a metallic layer, a metal plated layer, and a blackening layer in this order.

5. The optical filter as claimed in Claim 3 or 4, wherein the blackening layer is made of a nickel-zinc alloy, or nickel-tin alloy.

6. The optical filter as claimed in any of Claims 1 to 5, wherein the thickness of the electromagnetic shield layer is in the range of 0.01 to 8 µm.

7. The optical filter as claimed in any of Claims 1 to 6, wherein the functional layer is selected from a group consisting of a hard coat layer and a near infrared absorption layer.

8. The optical filter as claimed in Claim 7, further comprising a low refractive index layer on the hard coat layer.

9. The optical filter as claimed in any of Claims 1 to 8, wherein the functional layer is a hard coat layer, and the hard coat layer is provided on the electromagnetic shield layer, and a near infrared absorption layer is provided on another side of the transparent substrate that has no electromagnetic shield layer.

10. The optical filter as claimed in Claim 9, further comprising a transparent adhesive layer on the near infrared absorption layer.

11. The optical filter as claimed in any of Claims 1 to 10, wherein the optical filter is used for a display panel.

12. The optical filter as claimed in any of Claims 1 to 10, wherein the optical filter is applied to a glass plate by a transparent adhesive agent.

13. A display apparatus comprising:
an image display glass plate; and
the optical filter as claimed in any of Claims 1 to 10 applied to the surface of the image display glass plate.
